Europäisches Patentamt

European Patent Office

Office européen des brevets

(19)

(11) EP 1 227 592 A2

(12) **EUROPEAN PATENT APPLICATION**

(43) Date of publication:
31.07.2002  Bulletin 2002/31

(51) Int Cl.⁷: $H03L\ 7/18$

(21) Application number: 02250049.0

(22) Date of filing: 04.01.2002

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(30) Priority: **10.01.2001  JP 2001002901**<br><br>(71) Applicant: **MATSUSHITA ELECTRIC INDUSTRIAL CO., LTD.**<br>**Kadoma-shi, Osaka 571-8501 (JP)** | (72) Inventors:<br>• **Hirano, Shunsuke**<br>**Yokohama 245-0061 (JP)**<br>• **Yasunaga, Takeshi**<br>**Yokohama 240-0042 (JP)**<br>• **Miyahara, Yasunori**<br>**Ayase-shi, Kanagawa-ken 252-1113 (JP)**<br><br>(74) Representative: **Leeming, John Gerard**<br>**J.A. Kemp & Co.,**<br>**14 South Square,**<br>**Gray's Inn**<br>**London WC1R 5LX (GB)** |

(54)     **Frequency synthesizer and method of generating frequency-divided signal**

(57)     In a frequency synthesizer, a voltage controlled oscillator has a terminal and oscillates a signal whose frequency corresponds to a control signal applied to the terminal. A first frequency divider divides the frequency of the signal outputted from the voltage controlled oscillator so as to output a first frequency-divided signal. The first frequency-divided signal has a divided frequency. A comparator compares a phase of the first frequency-divided signal with that of a reference signal so as to output a difference signal representing a difference between the phase of the first frequency-divided signal and that of the reference signal. A loop filter smoothes the difference signal outputted from the comparator so as to output the smoothed signal as the control signal to the terminal of the voltage controlled oscillator. A frequency division unit divides the frequency of the signal outputted from the voltage control oscillator so as to output a second frequency-divided signal. The second frequency-divided signal has a divided frequency. A mixer unit mixes the second frequency-divided signal outputted from the frequency division unit and the signal outputted from the voltage control oscillator so as to output a mixed signal.

FIG. 1

EP 1 227 592 A2

**Description**

The present invention relates to a frequency synthesizer used to a mobile radio device and a method of generating a frequency-divided signal, which are capable of stably obtaining an excellent C/N characteristic (ratio) over a wide frequency band.

In cases of a mobile radio device such as a cellular phone, a frequency synthesizer is used for generating an arbitrary local oscillating frequency from a reference signal. Recently, it is desired to realize a cellular phone itself capable of dealing with a plurality of mobile communication systems, such as GSM (Grobal System for Mobile Communication), IMT (International Mobile Communications) 2000 and the like, whose frequency bands are different from each other. To make the cellular phone deal with the plurality of mobile communication systems, the frequency synthesizer must be operated over a wide frequency range.

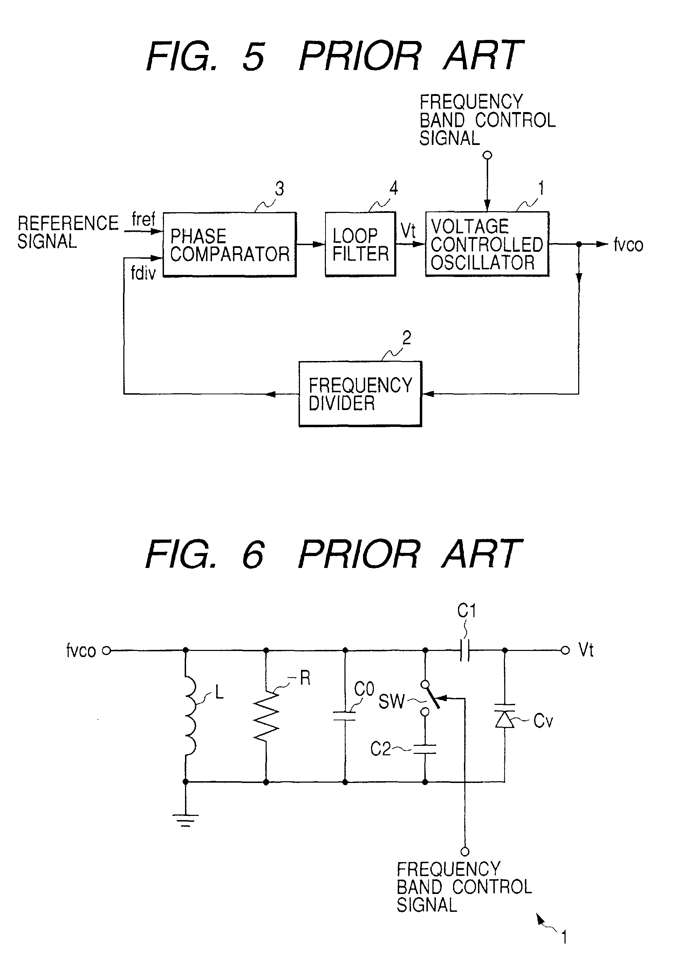

The frequency synthesizer used to these cellular phones, as shown in Fig. 5, comprises a voltage controlled oscillator 1 for setting a signal into oscillation, signal whose frequency corresponds to a voltage (Vt) applied to its frequency control voltage terminal, thereby permitting a frequency band of the oscillating signal (output signal) to be changed according to the frequency band control signal. The voltage controlled oscillator 1 is referred to as "VCO", hereinafter.

The frequency synthesizer also comprises an adjustable frequency divider 2 for dividing a frequency of the output signal from the VCO 1, whose frequency is referred to as "fvco" hereinafter, and a phase comparator 3 for comparing a phase of the output signal (frequency-divided signal) from the frequency divider 2, whose frequency is referred to as "fdiv" hereinafter, with that of a reference signal, whose frequency is referred to as "fref" hereinafter, thereby outputting a signal representing a difference between the phase-of the output signal (fdiv) and that of the reference signal (fref). The frequency synthesizer comprises a loop filter 4 for smoothing the signal outputted from the phase comparator 3.

Fig. 6 is a circuit diagram indicating a principle upon which the VCO 1 operates. The VCO 1 comprises a capacitor C0, a negative resistor -R and an inductor L, which are connected in parallel with each other.

The VCO 1 also comprises a capacitor C1 and a variable capacitor Cv, which are connected in series with each other. The in-series portion of capacitor C1 and the variable capacitor Cv is connected with the capacitor C0 in parallel. The VCO 1 further comprises a capacitor C2 and a switch SW which are connected in series with each other. The in-series portion of the capacitor C2 and the switch SW is connected with the capacitance C0 in parallel.

Next, the operations of the circuit diagram in Fig. 6 are explained.

The in-parallel portion of the negative resistor -R, the capacitance C0 and the inductor L is taken as a parallel circuit with an active element, such as a transistor or the like, and the active element is subjected to source voltage to generate power. The negative resistor -R is different from a usual resistor because the negative resistor -R generates power. An oscillating frequency of the VCO 1, that is, the frequency fcvo of the output signal from the VCO 1 is expressed as the equation (1) in cases where the switch SW is OFF or expressed as the equation (2) in cases where the switch SW is ON:

$$\text{fvco}|_{SW=OFF} = 1/[2\pi\sqrt{\{L(C0+C1\cdot Cv/(C1+Cv))\}}] \tag{1}$$

$$\text{fvco}|_{SW=ON} = 1/[2\pi\sqrt{\{L(C0+C2+C1\cdot Cv/(C1+Cv))\}}] \tag{2}$$

This shows that the VCO 1 permits the oscillating frequency band to vary with the ON/OFF of the switch SW.

When the VCO is applied to the frequency synthesizer, shown in Fig. 6, the control voltage is applied to the variable capacitor Cv, causing the capacitance of the variable capacitor Cv to vary, thereby making vary the oscillating frequency fvco.

In this frequency synthesizer shown in Fig. 5, varying the division frequency ratio of the variable frequency divider 2 causes the frequency fdiv of the output signal from the frequency divider 2 to be varied so that the phase comparator 3 outputs a phase difference signal between the output signal (fdiv) and the reference signal (fref).

The outputted phase difference signal is sent through the loop filter 4 to the VCO 1, causing the voltage Vt of the frequency control voltage terminal to be varied, thus varying the output signal (fvco).

That is, the frequency synthesizer is configured as negative feedback loop so that, when finally the phase of the reference signal (fref) and that of the output signal (fdiv) coincide with each other, the phase of the output signal (fdiv) is locked to that of the reference signal (fref), whereby the frequency of the output signal (fvco) from the VCO 1 keeps to be stable.

Adjusting the frequency band control signal so as to set it in oscillation in a desired frequency band, and adjusting the dividing ratio of the variable frequency divider 2 permit the phase of the output signal (fvco) to be locked in the desired frequency band.

In the frequency synthesizer with the above function for switching the frequency band, however, dividing the capacitance in the VCO causes the frequency band to be adjusted so that the control sensitivity of the VCO, which represents a variation width of the oscillating frequency per 1 V of the control voltage, whose unit is [Hz/V], is simultaneously varied, whereby the C/N characteristic of the frequency synthesizer must be varied according to the selected (switched) frequency band.

Switching only the capacitance of the variable capacitor in VCO is insufficient to switch widely the frequency band so that it is necessary to switch the inductance of the inductor in VCO, making increase the circuit size of the VCO.

When the frequency band is forced to be switched by only switching the capacitance in the VCO, the balance of the inductance and the capacitance is deteriorated to weak the oscillating power, thereby decreasing the output level of the VCO and, in some cases, causing the oscillating of the VCO to be stopped.

Adding a switch or the like into the resonant circuit causes the ON resistance and the parasitic capacitance of the added switch to decrease the quality factor Q of the oscillator, thereby deteriorating the C/N of the VCO itself.

In addition, in cases of using the above frequency synthesizer in a mobile radio device, the frequency band used in the frequency synthesizer makes change the communication quality of the mobile radio device.

The present invention is directed to overcome the foregoing disadvantages. Accordingly, it is an object of the present invention to provide a frequency synthesizer and a method of generating a frequency-divided signal, which are capable of switching its frequency band without greatly changing the C/N characteristic thereof.

According to one aspect of the present invention, there is provided a frequency synthesizer comprising: a voltage controlled oscillator having a terminal for oscillating a signal whose frequency corresponds to a control signal applied to the terminal; a first frequency divider for dividing the frequency of the signal outputted from the voltage controlled oscillator so as to output a first frequency-divided signal, said first frequency-divided signal having a divided frequency; a comparator for comparing a phase of the first frequency-divided signal with that of a reference signal so as to output a difference signal representing a difference between the phase of the first frequency-divided signal and that of the reference signal; a loop filter for smoothing the difference signal outputted from the comparator so as to output the smoothed signal as the control signal to the terminal of the voltage controlled oscillator; a frequency division unit for dividing the frequency of the signal outputted from the voltage control oscillator so as to output a second frequency-divided signal, said second frequency-divided signal having a divided frequency; and a mixer unit for mixing the second frequency-divided signal outputted from the frequency division unit and the signal outputted from the voltage control oscillator so as to output a mixed signal.

According to another aspect of the present invention, there is provided a method of generating a frequency divided signal, comprising the steps of: oscillating by a voltage controlled oscillator a signal whose frequency corresponds to a control signal, said voltage controlled oscillator having a terminal, said control signal being applied to the terminal; dividing by a first frequency divider the frequency of the signal outputted from the voltage controlled oscillator so as to output a divided signal, said divided signal having a divided frequency; comparing by a comparator a phase of the divided signal with that of a reference signal so as to output a difference signal representing a difference between the phase of the divided signal and that of the reference signal; smoothing the difference signal outputted from the comparator so as to supply the smoothed signal as the control signal to the terminal of the voltage controlled oscillator; and mixing by a mixer unit a frequency-divided signal and the signal outputted from the voltage control oscillator so as to output a mixed signal, said frequency-divided signal being obtained by dividing the frequency of the signal outputted from the voltage controlled oscillator.

According to one and another aspects of the present invention, only controlling the frequency division ratio of the frequency division unit and the operating mode (upconvert mode or downconvert mode) of the mixer unit permits the frequency band to be switched, thereby setting the frequency division ratio and the operating mode in no relation to a PLL (Phase Locked Loop). This causes, even if the frequency band is switched, the characteristic of the loop to be invariable, thereby making the control sensitivity of the voltage controlled oscillator and the C/N characteristic thereof invariable, too. In addition, the oscillating power of the voltage controlled oscillator is prevented from decreasing and the oscillating operation thereof is prevented from stopping.

Other objects and aspects of the present invention will become apparent from the following description of exemplary embodiments with reference to the accompanying drawings in which:

Fig. 1 is a block diagram schematically showing a configuration of a frequency synthesizer according to a first embodiment of the present invention;

Fig. 2 is a circuit diagram indicating a principal upon which a VCO shown in Fig. 1 operates according to the first embodiment of the present invention;

Fig. 3 is a circuit diagram showing a configuration of a mixer unit shown in Fig. 1 according to the first embodiment of the present invention;

Fig. 4 is a block diagram schematically showing a configuration of a frequency synthesizer according to a first embodiment of the present invention;

Fig. 5 is a block diagram schematically showing a configuration of a conventional frequency synthesizer; and

Fig. 6 is a circuit diagram indicating a principal upon which a VCO shown in Fig. 5.

Embodiments of the present invention will be described hereinafter with reference to the accompanying drawings.

Incidentally, elements which are the same as those shown in Fig. 5 are assigned to the same characteristic numerals of the elements shown in Fig.5, thereby omitting the detailed description.

(First embodiment)

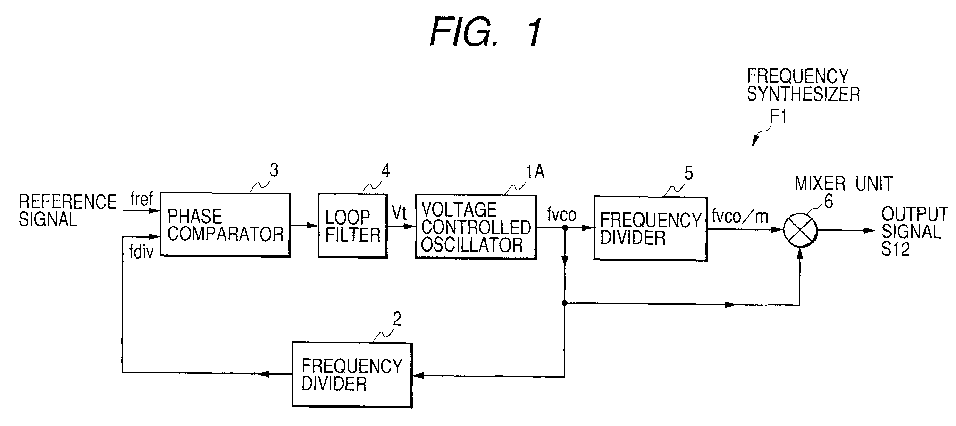

A frequency synthesizer F1 according to a first embodiment of the present invention, as shown in Fig. 1, comprises a VCO 1A, a frequency divider 2, a phase comparator 3 and a loop filter 4, which are similar to the structure shown in Fig. 5.

In addition, the frequency synthesizer F1 comprises a frequency divider 5 for dividing an output signal from the VCO 1 on the basis of the frequency division ratio previously set according to the control signal, and a mixer unit 6 for mixing an output signal from the frequency divider 2 and the output signal from the VCO 1A, which are the differential point as compared with the conventional frequency synthesizer shown in Fig. 5.

Another different point between the frequency synthesizer F1 of the present invention and a conventional frequency synthesizer is that the VCO 1A comprises no frequency switching function.

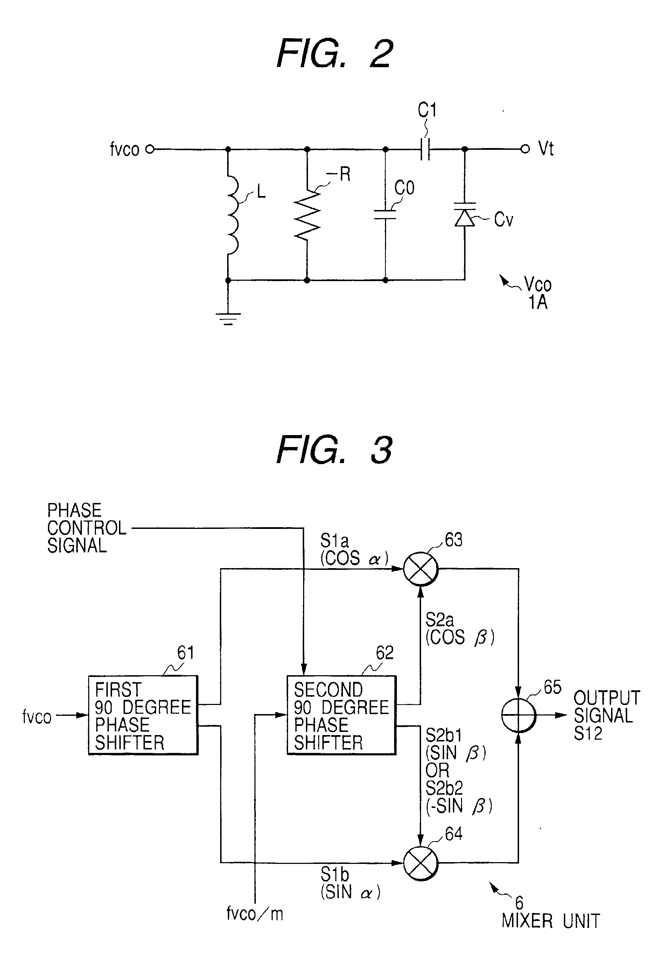

That is, Fig. 2 is a circuit diagram indicating a principle upon which the VCO 1A operates.

Different point between the VCO 1A of the first embodiment and the VCO 1 shown in Fig. 6 is that the switch SW and the variable capacitor C2 corresponding to the frequency switching function are not provided for the VCO 1A. Remained points of the VCO 1A except for the different point are the same as the VCO 1.

Therefore, the frequency fcvo of the output signal from the VCO 1 is expressed as the equation (3):

$$fvco = 1/[2\pi\sqrt{\{L(C0+C1\times Cv/(C1+Cv)\}}] \qquad (3)$$

In this first embodiment, in order to simplify the explanation, the frequency divider 5 can switch the frequency division ratio into 1/m1 or 1/m2 so that the frequency divider 5 multiplies the frequency fvco of the output signal by the frequency division ratio, whereby to output the frequency-divided signal whose frequency is taken as fvco/m (m is m1 or m2). The mixer unit 6 is an image reject mixer unit capable of being switchably served as upconvert mixer and as a downconvert mixer according to the phase control signal.

Next, the operations of the frequency divider shown in Fig. 1 are explained.

The VCO 1A turns into the phase lock state through the process which is described as the operations of the conventional frequency synthesizer shown in the Prior Art.

When the mixer unit 6 is used as the upconvert mixer, in a case where the frequency division rate is set to m1 or m2, the frequency of the output signal from the mixer unit 6 is represented as fvco + fvco/m1 or fvco + fvco/m2 so that switching the frequency division ratio of the frequency divider 5 permits the frequency band of the output signal from the mixer unit 6 to be varied within the range between the fvco/m1 and the fvco/m2.

When the mixer unit 6 is used as the downconvert mixer, in a case where the frequency division rate is set to m1 or m2, the frequency of the output signal from the mixer unit 6 is represented as fvco - fvco/m1 or fvco - fvco/m2 so that switching the frequency division ratio of the frequency divider 5 permits the frequency band of the output signal from the mixer unit 6 to be varied within the range between fvco/m2 and fvco/m1 to be varied.

With secured frequency division ratio, that is, secured m1, it is possible to switch the mixer into the upconvert mixer and the downconvert mixer so as to switch the frequency band of the output signal from the mixer unit 6. At this time, the frequency of the output signal from the mixer unit 6 turns into a frequency of (fvco + fvco/m1) or (fvco - fvco/m1), thereby making it possible to vary the frequency band corresponding to two times the frequency of fvco/m1.

It is usually known that dividing a frequency of a signal causes its C/N characteristic to be increased. In the frequency synthesizer F1 of the first embodiment according to the present invention, because of mixing the frequency-divided signal outputted from the mixer unit 6 and the output signal therefrom, the C/N characteristic of the output signal of the mixer unit 6 is determined by the C/N characteristic of the output signal from the VCO 1A so that, even when varying the frequency band, the C/N of the output signal from the mixer unit 6 is not greatly changed.

Next, the structure of the mixer unit 6 is explained in detail in reference to Fig. 3. The mixer unit 6 comprises a first 90 degree phase shifter 61 for dividing the output signal fvco from the VCO 1A into signals S1a (cos $\alpha$) and S1b (sin $\alpha$). Between the phase (cos $\alpha$) of the signal S1a (cos $\alpha$) and that (sin $\alpha$) of the signal S1b (sin $\alpha$), 90 degree phase

shift occurs.

The mixer unit 6 comprises a second 90 degree phase shifter 62 for dividing the output signal from the frequency divider 5 into signals S2a (cos β) and S2b (sin β). Between the phase (cos β) of the signal S2a (cos β) and that (sin β) of the signal S2b1 (sin β), 90 degree phase shift occurs.

The mixer unit 6 also comprises a first mixer 63 for mixing the signal S1a (cos $\alpha$) outputted as one side from the first shifter 61 and the signal S2a (cos β) outputted as one side from the second shifter 62, and a second mixer 64 for mixing the signal S1b (sin $\alpha$) outputted as other side from the first shifter 61 and the signal S2b1 (sin β) outputted as other side from the second shifter 62. The mixer unit 6 further comprises an adder 65 for adding the output signals from the first and second mixers 63 and 64.

The phase control signal is inputted in the second 90 degree shifter 62 so that the 90 degree shifter 62 can output a signal S2b2 (-sin β ) whose phase (-sin β) is reversed from the phase (sin β) of the signal S2b1 (sin β).

That is, in this embodiment, the phase shifter 62 can switchably output the signal S2b1 (sin β) or the signal S2b2 (-sin β) according to the content of the phase control signal.

When integrating the phase shifter in IC (Integrated Circuit), the phase shifter is usually configured as a differential circuit so that only switching positive phase signal and negative phase signal simply permits the phase to be reversed.

Next, the operations of the mixer unit 6 is explained by using calculation equations.

The first mixer 63 mixes the output signal S1a (cos $\alpha$) outputted from the first shifter 61 and the signal S2a (cos β) outputted from the second shifter 62 so as to output a signal S10 represented as the equation (4).

$$S10 = \cos \alpha \cos \beta = 1/2\{\cos(\alpha+\beta)+\cos(\alpha-\beta)\} \tag{4}$$

When the content of the phase control signal inputted in the phase shifter 62 represents that the signal S2b1 (sin β) is selected, the second mixer 64 mixes the output signal S1b (sin $\alpha$) outputted from the first shifter 61 and the signal S2b1 (sin β) outputted from the second shifter 62 so as to output a signal S11 represented as the equation (5).

$$S11 = \sin \alpha \sin \beta = 1/2\{\cos(\alpha+\beta)+\cos(\alpha-\beta)\} \tag{5}$$

The equations (4) and (5) clearly shows that the output signal S12 from the adder 65, which is the same as the output signal from the mixer unit 6, is represented as the equation (6).

$$S12 = \cos (\alpha + \beta) \tag{6}$$

This equation (6) clearly shows that the image band of cos ($\alpha$ - β) is rejected so that the mixer unit 6 operates as the upconvert mixer, thereby outputting the signal whose frequency is fvco + fvco/m.

On the other hand, when the content of the phase control signal inputted in the phase shifter 62 represents that the signal S2b2 (-sin β) is selected, the second mixer 64 mixes the output signal S1b (sin $\alpha$) outputted from the first shifter 61 and the signal S2b2 (-sin β) outputted from the second shifter 62 so as to output a signal S12 represented as the equation (7).

$$S12 = -\sin \alpha \sin \beta = -1/2\{\cos(\alpha+\beta) - \cos(\alpha-\beta)\} \tag{7}$$

The equations (4) and (7) clearly shows that the output signal S12 from the adder 65, which is the same as the output signal from the mixer unit 6, is represented as the equation (8).

$$S12 = \cos (\alpha - \beta) \tag{8}$$

This equation (8) clearly shows that the image band of cos ($\alpha$ + β) is rejected so that the mixer unit 6 operates as the downconvert mixer, thereby outputting the signal whose frequency is fvco - fvco/m.

As described above, in the frequency synthesizer F1, only controlling the frequency division ratio of the frequency divider 5 and the operating mode (upconvert mode or downconvert mode) of the mixer unit 6 permits the frequency band to be switched, thereby setting the frequency division ratio and the operating mode in no relation to a PLL (Phase Locked Loop) corresponding to the structure shown in Fig. 1. This causes, even if the frequency band is switched, the characteristic of the loop to be invariable, thereby making the control sensitivity of the VCO 1A and the C/N characteristic thereof invariable, too.

The VCO 1A has no frequency switching function and no elements required therefor so that it is possible to improve the quality factor Q of the VCO 1A, permitting the C/N characteristic of the VCO 1A itself to be improved. In addition, the oscillating power of the VCO 1A is prevented from decreasing and the oscillating operation thereof is prevented from stopping.

Because the frequency of the output signal from the mixer unit 6 is remarkably varied, the image reject mixer unit is used as the mixer unit 6 so that no variable band filter is required for preventing the image band on an output side of the mixer unit 6.

It is possible to switchably use the mixer unit 6 as the upconvert mixer and the downconvert mixer, permitting the frequency band of the frequency synthesizer F1 to be widely adjusted.

Incidentally, in the above description, the frequency divider can switch the frequency division ratio into either one of two values, whereas according to the similar consideration, it is possible to switch the frequency division ratio into one of numbers of values. In this case, it is possible to improve the freedom of setting the switching width of the frequency band.

In cases where the frequency divider 5 has function for switching its frequency division ratio, no switching function between the upconvert and downconvert may be provided for the frequency synthesizer F1, making compact the circuit size thereof.

The variable frequency divider 2 may be configured to temporally vary its frequency division ratio, like as a fractional-N system usually known, so as to obtain the same effects. In this case, it is possible to set the frequency steps obtained from the output signal from the VCO 1A so that each step width is shorter than that of the reference signal (fref), increasing the freedom of setting the frequency division ratio of the frequency divider 5.

In addition, installing the frequency synthesizer F1 according to the first embodiment into a mobile radio device permits the communication quality to be stable in no relation to the frequency band to be used.

(Second embodiment)

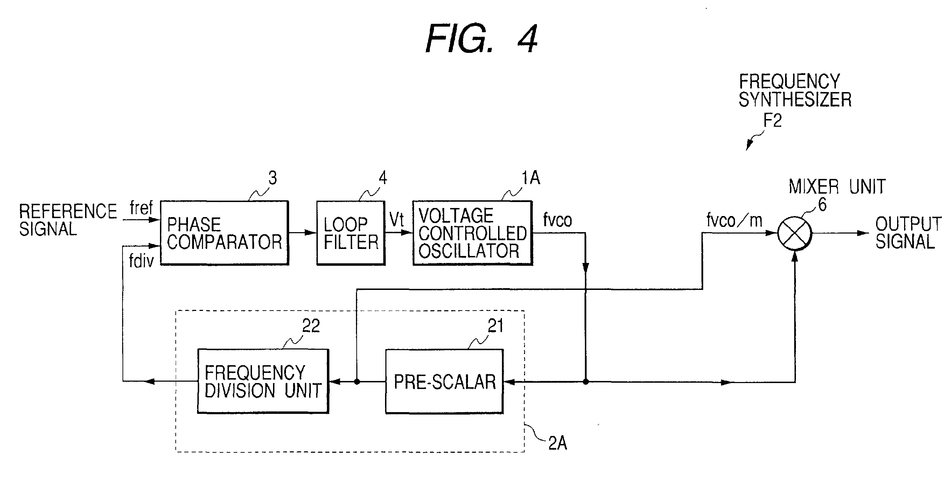

A frequency synthesizer F2 according to a second embodiment of the present invention, as shown in Fig. 4, comprises a frequency divider 2A having a pre-scalar 21 and a frequency division unit 22 whose output terminal is connected with the mixer unit 6.

The pre-scalar 21 previously divides the frequency fvco of the output signal from the VCO 1A by the frequency division ratio of m (m1 or m2) so at to output the output signal whose frequency is represented as fvco/m to the frequency division unit 22 and the mixer unit 6.

The frequency division unit 22 divides the frequency fvco/m of the output signal from the pre-scalar 21 by the frequency division ratio which is (1/m) times the frequency division ratio of the frequency divider 2 shown in Fig. 1.

The configuration of the frequency divider 2A is the differential point as compared with the frequency synthesizer F1 shown in Fig. 1, so that elements which are the same as those shown in Figs. 1 and 5 are assigned to the same characteristic numerals of the elements shown in Figs. 1 and 5, thereby omitting the detailed description.

In this structure of the second embodiment, no frequency divider 5 is required.

Operations of the frequency synthesizer F2 are explained.

In this second embodiment, the frequency fvco of the output signal from the VCO 1A is inputted in the pre-scalar 21 so as to be divided into the frequency fvco/m so that the output signal whose frequency is fvco/m is outputted to the mixer unit 6, like the first embodiment, and the frequency division unit 22.

The frequency fvco/m of the output signal from the pre-scalar 21 is divided by the frequency division unit 22 on the basis of the frequency division ratio which is (1/m) times the frequency division ratio of the frequency divider 2 so that the frequency of the output signal from the frequency divider 2A (frequency division unit 22) is set to the fdiv which is the same as that of the output signal from the frequency divider 2.

Furthermore, because the mixer unit 6 executes the same operations as the first embodiment, it is possible to obtain the above effects described above without using the frequency divider 5.

A mobile radio device such as cellular phone or the like has an oscillating frequency which is the range of hundreds MHz to several GHz so that the power consumption of each frequency divider for dividing the frequency is made large. When the frequency synthesizer F2 according to the second embodiment is installed into a mobile radio device, it is possible to decrease a number of frequency dividers for dividing the oscillating frequency of the VCO, making it possible to decrease the power consumption in the mobile radio device.

While there has been described what is at present considered to be the preferred embodiment and modifications of the present invention, it will be understood that various modifications which are not described yet may be made therein, and it is intended to cover in the appended claims all such modifications as fall within the scope of the invention as defined by the appended claims.

**Claims**

1.  A frequency synthesizer comprising:

    a voltage controlled oscillator having a terminal for oscillating a signal whose frequency corresponds to a control signal applied to the terminal;
    a first frequency divider for dividing the frequency of the signal outputted from the voltage controlled oscillator so as to output a first frequency-divided signal, said first frequency-divided signal having a divided frequency;
    a comparator for comparing a phase of the first frequency-divided signal with that of a reference signal so as to output a difference signal representing a difference between the phase of the first frequency-divided signal and that of the reference signal;
    a loop filter for smoothing the difference signal outputted from the comparator so as to output the smoothed signal as the control signal to the terminal of the voltage controlled oscillator;
    a frequency division unit for dividing the frequency of the signal outputted from the voltage control oscillator so as to output a second frequency-divided signal, said second frequency-divided signal having a divided frequency; and
    a mixer unit for mixing the second frequency-divided signal outputted from the frequency division unit and the signal outputted from the voltage control oscillator so as to output a mixed signal.

2.  A frequency synthesizer according to claim 1, wherein said frequency division unit comprises a second frequency divider for dividing the frequency of the signal outputted from the voltage control oscillator.

3.  A frequency synthesizer according to claim 2, wherein said second frequency divider divides the frequency of the signal outputted from the voltage control oscillator on the basis of a frequency division ratio, said second frequency divider switchably setting the frequency division ratio.

4.  A frequency synthesizer according to claim 1, 2 or 3, wherein said first frequency divider comprises a pre-scalar for dividing the frequency of the signal outputted from the voltage control oscillator and a third frequency divider connected therewith in series, said third frequency divider being adapted to divide an output signal outputted from the pre-scalar, said pre-scalar being served as the frequency division unit so as to supply the signal outputted from the pre-scalar to the mixer unit.

5.  A frequency synthesizer according to claim 1, 2, 3, or 4, wherein said mixer unit comprises:

    a first phase shifter adapted to generate first and second signals, said first signal being shifted 90 degree away from the second signal;
    a second phase shifter adapted to generate third and fourth signals, said third signal being shifted 90 degree away from the fourth signal;
    a first mixer adapted to mix one of the first and second signals outputted from the first phase shifter and one of the third and fourth signals outputted from the second phase shifter;
    a second mixer adapted to mix other of the first and second signals outputted from the first phase shifter and other of the third and fourth signals outputted from the second phase shifter; and
    an adder adapted to add a mixed signal by the first mixer and a mixed signal by the second mixer.

6.  A frequency synthesizer according to any one of the preceding claims, wherein said mixer unit is switchable to serve as an upconvert mixer and a downconvert mixer according to an external control signal.

7.  A frequency synthesizer according to any one of the preceding claims, wherein said frequency division unit has a frequency division ration, said frequency division ration being a secured value.

8.  A frequency synthesizer according to any one of claims 1 to 6, wherein said frequency division unit has a frequency division ratio for temporally varying the frequency division ratio so as to set an averaged value from the temporally varied frequency division ratios to a desired frequency division ratio.

9.  A method of generating a frequency divided signal, comprising the steps of:

    oscillating by a voltage controlled oscillator a signal whose frequency corresponds to a control signal, said voltage controlled oscillator having a terminal, said control signal being applied to the terminal;

dividing by a first frequency divider the frequency of the signal outputted from the voltage controlled oscillator so as to output a divided signal, said divided signal having a divided frequency;

comparing by a comparator a phase of the divided signal with that of a reference signal so as to output a difference signal representing a difference between the phase of the divided signal and that of the reference signal;

smoothing the difference signal outputted from the comparator so as to supply the smoothed signal as the control signal to the terminal of the voltage controlled oscillator; and

mixing by a mixer unit a frequency-divided signal and the signal outputted from the voltage control oscillator so as to output a mixed signal, said frequency-divided signal being obtained by dividing the frequency of the signal outputted from the voltage controlled oscillator

**10.** A method of generating a frequency divided signal according to claim 9, further comprising a step of dividing by a second frequency divider the frequency of the signal outputted from the voltage control oscillator so as to supply a signal outputted from the second frequency divider as the frequency-divided signal to the mixer unit.

**11.** A method of generating a frequency divided signal according to claim 10, further comprising a step of switching a frequency division ratio of the second frequency divider so as to vary a frequency band of the mixed signal outputted from the mixer unit.

**12.** A method of generating a frequency divided signal according to claim 9, 10 or 11, wherein said first frequency divider comprises a pre-scalar and a third frequency divider, further comprising the steps of:

dividing by the pre-scalar the frequency of the signal outputted from the voltage control oscillator;

dividing by the third frequency divider a frequency of an output signal outputted from the pre-scalar so as to supply the divided signal to the phase comparator; and

supplying the output signal outputted from the pre-scalar as the frequency-divided signal to the mixer unit.

**13.** A method of generating a frequency divided signal according to claim 9, 10, 11 or 12, wherein said mixer unit comprises a first shifter, a second shifter, a first mixer, a second mixer and an adder, wherein said mixing step comprises the steps of:

generating by the first phase shifter first and second signals, said first signal being shifted 90 degree away from the second signal;

generating by the second phase shifter third and fourth signals, said third signal being shifted 90 degree away from the fourth signal;

mixing by the first mixer one of the first and second signals outputted from the first phase shifter and one of the third and fourth signals outputted from the second phase shifter;

mixing by the second mixer other of the first and second signals outputted from the first phase shifter and other of the third and fourth signals outputted from the second phase shifter; and

adding by the adder a mixed signal outputted from the first mixer and a mixed signal outputted from the second mixer.

**14.** A method of generating a frequency divided signal according to claim 9, 10, 11, 12 or 13,
further comprising the step of switching the first mixer into an operation mode of an upconvert mixer and that of a downconvert mode so as to vary a frequency band of the mixed signal outputted from the first mixer.

**15.** A method of generating a frequency divided signal according to claim 14, wherein said second frequency divider has a frequency division ratio, said frequency division ratio being a secured value.

**16.** A method of generating a frequency divided signal according to any one of claims 9 to 15, wherein said first frequency divider has a frequency division ratio for temporally varying the frequency division ratio so as to set an averaged value from the temporally varied frequency division ratios to a desired frequency division ratio.

**17.** A mobile radio device including a frequency synthesizer according to any one of claims 1 to 8.

## FIG. 1

FREQUENCY
SYNTHESIZER
F1

# FIG. 2

# FIG. 3

# FIG. 4

FREQUENCY
SYNTHESIZER
F2

EP 1 227 592 A2

# FIG. 5 PRIOR ART

# FIG. 6 PRIOR ART